# EUROPEAN PATENT APPLICATION

(11) **EP 2 088 844 A1**
(43) Date of publication of application: **12.08.2009**
(21) Application number: 08151087.7
(22) Date of filing: 05.02.2008
(51) Int. Cl.: H05K 13/04

(54) **Placement device, assembly device and method of placing a component**

(71) Applicant: Nederlandse Organisatie voor toegepast-natuurwetenschappelijk onderzoek TNO, 2628 VK Delft (NL)
(72) Inventor: The designation of the inventor has not yet been filed
(74) Representative: Hatzmann, Martin

(57) **Abstract**

The placement device (200) comprises a holder (210), a resilient body (220) coupled to the holder (210) and a gripper (230). The gripper (230) is coupled to a mounting section (222) of the resilient body (220) and extending in a direction of a z-axis. The mounting section (222) is movable in a arbitrary directions and capable of tilting away from the z-axis. The gripper (230) and the holder (210) respectively have a first (232) and a second (212) constrainment surface. The first constrainment surface (232) of the gripper (230) is arranged between the mounting section (222) of the resilient body (220) and the second constrainment surface (212) of the holder (210). In an unloaded state of the placement device (200) the resilient body (220) forces the first constrainment surface (232) of the gripper (230) against the second constrainment surface (212) of the holder (210).

## Description

### FIELD OF THE INVENTION

### The present invention relates to a placement device.

### The present invention further relates to an assembly device.

### The present invention still further relates to a method of placing a component.

### BACKGROUND OF THE INVENTION

Placement devices are used for assembling components, e.g. components in hybrid microsystems, or for placing components on a substrate, e.g. a printed circuit board. Additionally placement devices may be used for other pick & place activities, such as taking components from a component supply belt and placing them on a location for further processing. When placing a component, such as in surface mounted device (SMD) technology or in a micro structure technology (MST) application on a carrier, e.g. a printed circuit board or a wafer, the component will in practice not be aligned with the wafer when it approaches the latter. One point of the component initially contacts the carrier, and subsequently the component rotates round a rotating point defined by the placement device until it reaches its final position. As the rotation point defined by the gripper has a different position that the first contactpoint between the component and the carrier, the component is forced to shift with respect to the carrier to reach a position defined by the placement device. This results in a positioning inaccuracy.

WO9308113 discloses a known placement device, comprising a bellows, having a flexible rubber endpart for gripping a component and alignment means. In operation the gripper withdraws the component towards a holder, where it is aligned in a horizontal plane. Subsequently the lateral position is aligned by a pair of jaws.

### SUMMARY OF THE INVENTION

It is a purpose of the present invention to provide an improved placement device.

It is a further purpose of the present invention to provide an improved assembly device. It is a still further purpose of the present invention to provide an improved placement method.

According to a first aspect of the invention a placement device as claimed in claim 1 is provided.

According to a second aspect of the invention an assembly device as claimed in claim 6 is provided.

According to a third aspect of the invention a placement method as claimed in claim 7 is provided.

The placement device and placement method according to the invention initially, in an unloaded state, constrain the position and orientation of the component to be placed, but release the degrees of freedom X,Y, Z, Rx and Ry of the component when the component contacts the carrier. After the component contacts the carrier the placement device is loaded by the force that is exerted on it when an assembly device attempts to continue a movement of the placement device towards the carrier. Accordingly after its first contact with the carrier the component is allowed to move in arbitrary directions and to rotate around an arbitrary axis transverse to the z-axis, where the z-axis is the direction in which the component is placed. As these degrees of freedom are released upon the first contact of the component with the carrier, the component will rotate around the first point of contact until it is completely placed on the carrier. Hence, surprisingly, in the placement device according to the invention, releasing all but one degree of freedom during the placement, improves the placement accuracy of the component.

In the placement device known from WO9308113, the above-mentioned degrees of freedom are released before the component makes the first contact with the carrier where it is to be placed. This causes a placement error.

In the earlier filed, still unpublished European patent application 07110566.2 filed by the same applicant a placement device is described that is provided with a tilting member. The tilting member allows the gripper to tilt away from the z-axis. This prevents that a tilt angle of the placement device with respect to its moving direction results in lateral forces that could displace the component. The known placement device does not release the degrees of freedom X,Y.

The resilient body is for example a compressed volume of a resilient foam. The pressure exerted by the volume on the gripper causes the first constrainment surface of the gripper to rest against the second constrainment surface of the holder, so that the position and orientation of the gripper are fixed. Once the component to be placed has contacted the surface of the carrier a further progression of the holder to the surface causes the resilient body formed by the volume of foam to be further compressed, so that the first constrainment surface is released from the second constrainment surface. Now the position and orientation are no longer restrained by the constrainment surfaces. The mounting section is movable in a arbitrary directions and capable of tilting away from the z-axis. Accordingly the component is allowed to rotate around its first point of contact with the carrier, until it is completely and stably placed thereon.

In a preferred embodiment the resilient body is a bellow-shaped hollow body. The bellow-shaped hollow body may be made of a resilient material like rubber, or it may be constructed of a more rigid material and have resilient behaviour due to its shape e.g. by a construction of circular extending corrugations like folds. Such a bellows shaped hollow body provides for the degrees of freedom X,Y,Z and Rx, Ry, but constrains the degree of freedom Rz. In this way it is prevented that the component can rotate in the plane of the carrier during its placement. As the bellows is hollow, its inside can serve as a vacuum tube for the gripper. Alternatively a vacuum may be provided via a separate tube, or different means may be used for allowing the gripper to hold a component. Depending on the required tension to be exerted on the gripper in the z-direction, and the required resistance against displacements in the x and y direction as well as the required resistance against a tilt from the z-direction, the skilled person can select a suitable material, a value for the thickness of the walls of the bellows, a diameter of the bellows, a height of the bellows and a number of folds in the walls. The stiffness of the resilient body in the directions x,y in preferably considerably lower than the stiffness in the z-direction. The stiffness in the z-direction may be increased by using an additional resilient element.

In an embodiment the first and the second constrainment surface have a conical shape. The conical shapes of the constrainment surfaces allow the gripper to rapidly assume its reference position after the placement device is withdrawn. A conical shape having straight boundaries in a cross-section through the z-axis, but alternatively a shape having curved boundaries in said cross-section.

In an embodiment the constrainment surfaces taper inward in a direction towards the resilient body. In an embodiment the constrainment surfaces taper outward in a direction towards the resilient body. This has the advantage that the placement device can have a compact construction.

In an embodiment of the placement device the bellows partly encloses the gripper. This arrangement further facilitates a complex construction of the gripper.

An assembly device according to the invention comprising a placement device according to any of the previous embodiments and further comprising a displacement device for relatively displacing the placement device in a direction transverse to the z-axis.

### BRIEF DESCRIPTION OF THE DRAWINGS

These and other aspects of the invention are described in more detail with reference to the drawing.
Therein:
Figure 1 schematically shows an assembly device,
Figure 2 shows in cross-section a first embodiment of a placement device according to the invention in an unloaded state,
Figure 3A shows in cross-section a second embodiment of a placement device according to the invention in an unloaded state,
Figure 3B shows in cross-section the second embodiment of the placement device according to the invention in an intermediate state,
Figure 3C shows in cross-section the second embodiment of the placement device according to the invention in an compressed state,
Figure 4 shows in cross-section a third embodiment of a placement device according to the invention in an unloaded state,
Figure 5A shows a detail of a cross-section of a part of the placement device of Figures 3A-3C and 4,
Figure 5B a shows this part in an enlarged representation,
Figure 5C shows a variation of the part of Figure 5A, 5B,
Figure 5D shows a further variation of the part of Figure 5A, 5B,
Figure 6 shows in cross-section a fourth embodiment of a placement device according to the invention in an unloaded state.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

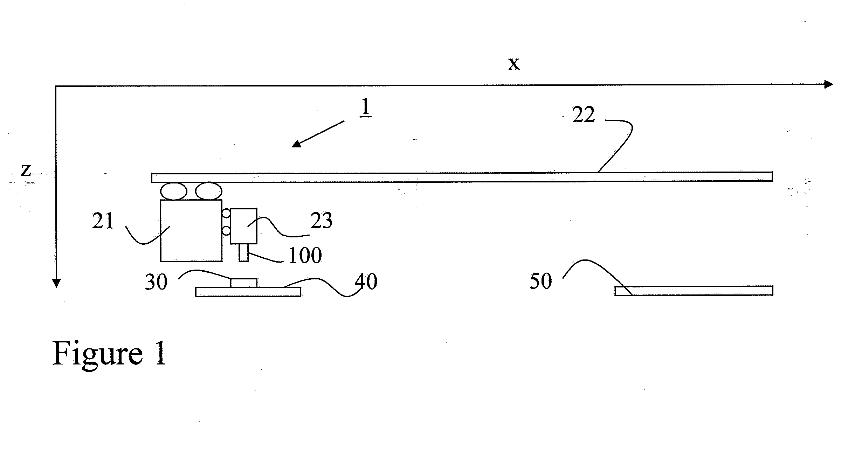

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention. Figure 1 schematically shows an assembly device 1. The assembly device 1 comprises a placement device 100 and a displacement device for relatively displacing the placement device 100 in a direction along a first axis (z) as well as a direction transverse to the first axis (x). The displacement device comprises a first sledge 21 that is moveable along the x-axis along a rail 22, and a second sledge 23 that is movable with relatively to the first sledge 21 in the z-direction. The placement device 100 is arranged to grip a component 30 from a conveyor belt 40 for example and after being displaced by the displacement device 21, 22, 23 mount this to a substrate, e.g. a printed circuit board 50. Although in the embodiment shown the first sledge 21 moves the placement device in a direction orthogonal to the z-direction the movement direction of the sledge may be in a direction orientated at another non-zero angle with the z-axis. Alternatively the displacement device may be capable of displacing the placement device in a range of directions.

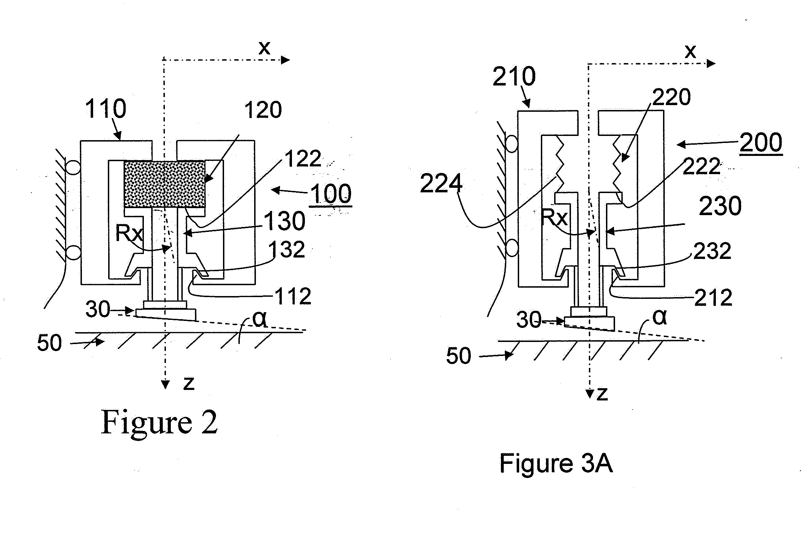

Figure 2 shows a first embodiment of a placement device 100 according to the invention. The placement device 100 is shown in a cross-section. The placement device 100 is substantially circular rotation symmetric around the z-axis. The placement device 100 comprises a holder 110, a resilient body 120 coupled to the holder 110 and a gripper 130. In the embodiment shown the resilient body 120 is a volume of elastic foam. The gripper 130 is coupled to a mounting section 122 of the resilient body 120 and extends in a direction of an z-axis. The mounting section 122 is movable in a arbitrary directions x (horizontal), y (orthogonal to the plane of the drawing, not shown) and is capable of tilting away from the z-axis in a direction Rx (in the plane of the drawing) and Ry (orthogonal to the plane of the drawing, not shown).

The gripper 130 and the holder 110 respectively have a first and a second constrainment surface 132, 112. The first constrainment surface 132 of the gripper 130 is arranged between the mounting section 122 of the resilient body 120 and the second constrainment 112 surface of the holder 110. Figure 2 shows an unloaded state of the placement device 100. Therein the resilient body 120 forces the first constrainment surface 132 of the gripper 130 against the second constrainment surface 112 of the holder 110. In the embodiment shown the first and the second constrainment surfaces 132, 112 have a conical shape. In particular the constrainment surfaces 132, 112 taper inward in a direction towards the resilient body 120.

In a practical implementation the gripper is a vacuum gripper, which is the most commonly used type of gripper applied in micro-assembly. However other embodiments are applicable, e.g. using electromagnetic force.

As shown in Figure 2, a bottom surface of the component 30 differs an angle α in alignment with a carrier, here a printed circuit board 50.

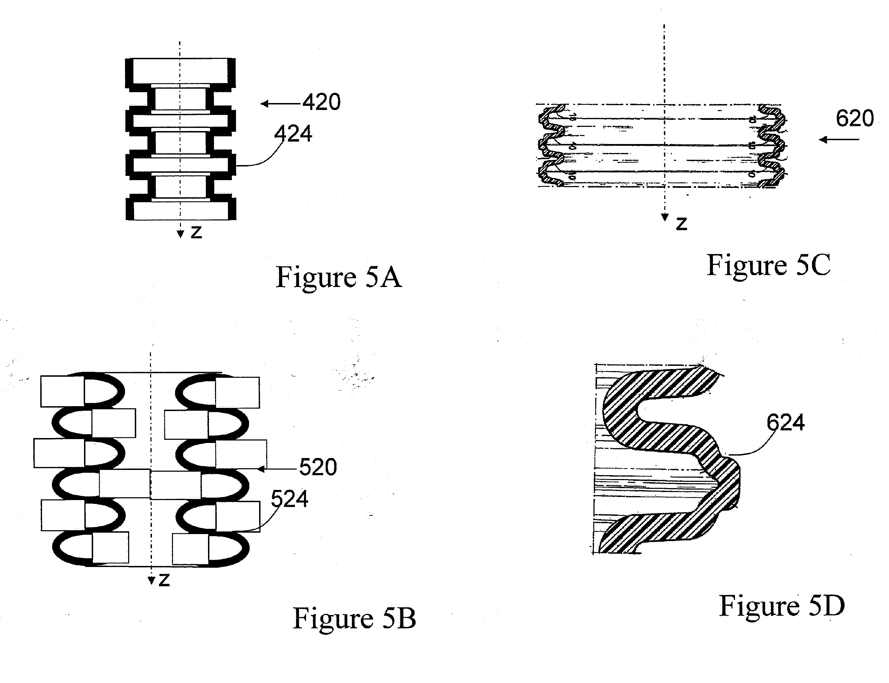

Figure 3A shows a second embodiment of a placement device according to the invention. In Figure 3A parts of the displacement device 200 corresponding to those of the placement device 100 in Figure 2 have a reference number that is 100 higher. The other reference numbers are identical to those in Figure 2. In the embodiment shown in Figure 3A, the resilient body 220 is a bellow-shaped hollow body of a resilient material. In this embodiment the resilient body is of a stainless steel.The hollow body 220 forms a vacuum tube for the gripper 130. As shown schematically in Figure 3A, the wall 224 of the bellow shaped body has a triangular shaped folds in a cross-section through the z-axis. Nevertheless other shapes are possible as is illustrated in Figures 5A-5D. Figure 3A, as well as Figure 2, show a state where the component 30 held by the placement device 200, 100 is still remote from the carrier 30. Hence, the placement device is unloaded.

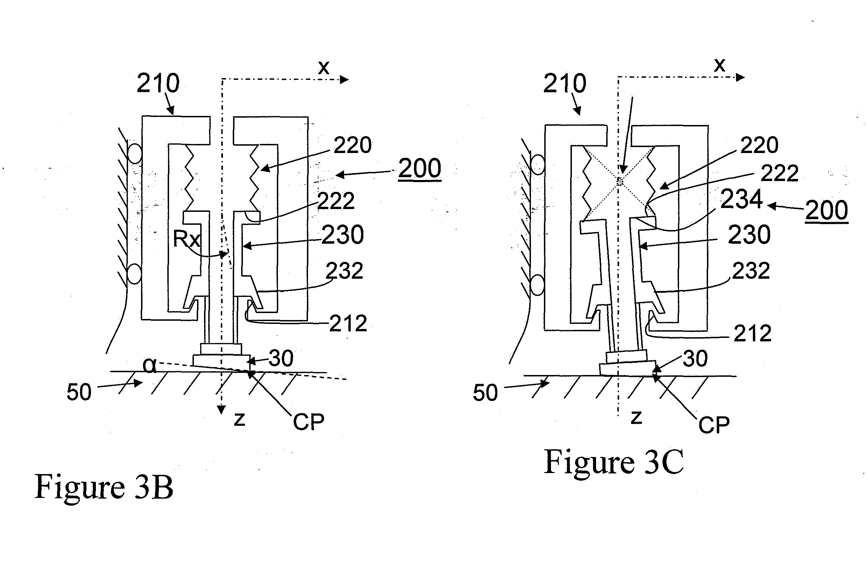

Figure 3B shows a transition state wherein the placement device 200 has moved towards the carrier until the component 30 carried by the placement device 200 touches the carrier 50 at a first contact point CP. The contact point CP determines a position of the component by friction between the surfaces of the component 30 and the carrier 50 contacting each other in the contact point CP. The movement of the placement device now progresses until the end state as shown in Figure 3C.

Due to the continuing movement of the displacement device 200 towards the surface of the carrier 50 and due to the fact that the component 30 is already constrained by the contact point P, the force exerted by the resilient body 220 is conquered. Consequently, the constrainment surface 232 of the gripper 230 is at least partially released from the constrainment surface 212 of the holder 210. The endportion 234 of the gripper 230 can now freely move in arbitrary directions and tilt away from the z-axis. As the gripper is allowed these degrees of freedom, the component is allowed to rotate around the contact point CP. Therewith the point of the component 30 that first contacted the carrier 50 is not forced to shift over the surface of the carrier 50. Moreover, in this preferred embodiment a rotation around the z-axis is blocked by the resilient body 220, so that the component 30 is even more accurately placed on the carrier 50.

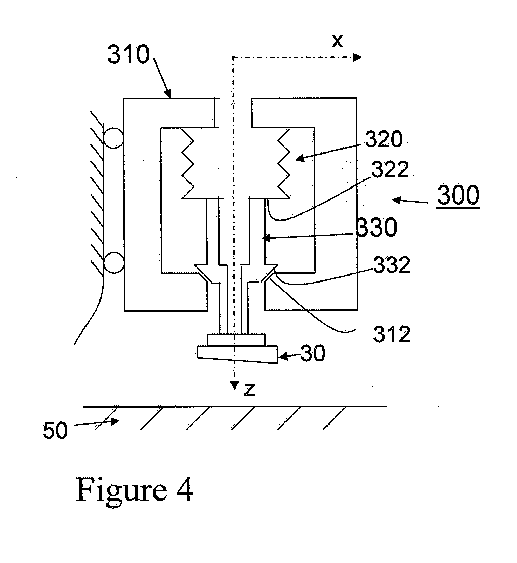

Figure 4 shows an alternative embodiment of a placement device 300 according to the invention. In Figure 4 parts of the displacement device 300 corresponding to those of the placement device 200 in Figure 3A-C have a reference number that is 100 higher. The other reference numbers are identical to those in Figure 3A-3C. The embodiment shown in Figure 4 differs from the embodiment of Figures 3A-3C in that the constrainment surfaces 312, 332 taper outward in a direction towards the resilient body 320.

Figures 5A-5D show various alternative embodiments for the shape of the wall 224 of the bellows 220. In Figure 5A, parts corresponding to those in Figure 3A have a value that is 200 higher. The wall 424 of the bellow shaped body 420 therein has a rectangular shaped folds in a cross-section through the z-axis. In Figure 5B, parts corresponding to those in Figure 3A have a value that is 300 higher. The wall 524 of the bellow shaped body 520 therein has simple curved folds in a cross-section through the z-axis. Also more complex shapes are possible, as shown in Figure 5C and the detail thereof in Figure 5D. Therein parts corresponding to those in Figure 3A have a value that is 400 higher.

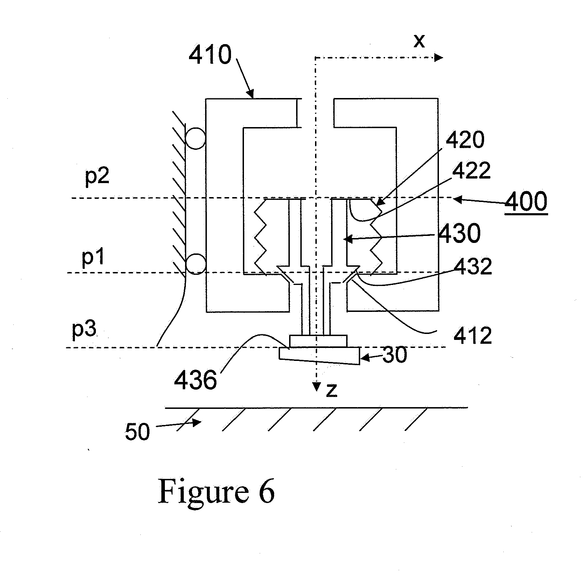

It is not necessary that the bellows is arranged in line with the gripper. Alternatively the bellows may be enclosed by the gripper, as is illustrated in Figure 6. In Figure 6, parts corresponding to those in Figure 4 (other than the component 30 and the substrate 50) have a reference number that is 100 higher. In Figure 6 the bellows 420 encloses the gripper 430. The bellows is mounted to the holder 300 in a plane p1 through the z-axis between a plane p2 through the mounting section 422 and a plane p3 through an end portion 236 for gripping the component 30.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. Placement device (200) comprising
- a holder (210),
- a resilient body (220) coupled to the holder (210),
- a gripper (230) coupled to a mounting section (222) of the resilient body (220) and extending in a direction of a z-axis, the mounting section (222) being movable in a arbitrary directions and being capable of tilting away from the z-axis,
- wherein the gripper (230) and the holder (210) respectively have a first (232) and a second (212) constrainment surface, the first constrainment surface (232) of the gripper (230) being arranged between the mounting section (222) of the resilient body (220) and the second constrainment surface (212) of the holder (210), wherein, in an unloaded state of the placement device (200) the resilient body (220) forces the first constrainment surface (232) of the gripper (230) against the second constrainment surface (212) of the holder (210).

2. Placement device according to claim 1, wherein the resilient body (220) is a bellow-shaped hollow body.

3. Placement device according to claim 1, wherein the first (232) and the second constrainment surface (212) have a conical shape.

4. Placement device according to claim 3, wherein the constrainment surfaces (232, 212) taper inward in a direction towards the resilient body (220).

5. Placement device according to claim 3, wherein the constrainment surfaces (332, 312) taper outward in a direction towards the resilient body (320).

6. Placement device according to claim 2, wherein the bellows (420) partly encloses the gripper (430).

7. An assembly device comprising a placement device according to any of the previous claims and further comprising a displacement device (21, 22, 23) for relatively displacing the placement device (10) in a direction (x) transverse to the z-axis.

8. Method of placing a component on a carrier, comprising the steps of
- fetching a component,
- moving the component towards the carrier, while restraining all degrees of freedom of the component,
- upon a first contact between the component and the carrier, releasing the degrees of freedom X,Y,Z,Rx,Ry, while restraining the degree of freedom Rz, wherein Z is the position of the component in a direction transverse to a plane of the carrier, and X and Y are mutually transverse directions indicating a position within said plane, and Rx, and Ry define a degree of freedom of rotating around said X-axis and said Y-axis, and Rz indicates the restrained freedom of rotating around the Z-axis.
